# EUROPÄISCHE PATENTSCHRIFT

(11) **EP 2 873 985 B1**
(45) Veröffentlichungstag und Bekanntmachung des Hinweises auf die Patenterteilung: **30.11.2016**
(21) Anmeldenummer: 14003656.7
(22) Anmeldetag: 28.10.2014
(51) Int. Cl.: G01R 33/07

(54) **Hallsensorvorrichtung**
Hall sensor device
Dispositif à capteur Hall

(30) Priorität: 29.10.2013 DE 102013018370
(43) Veröffentlichungstag der Anmeldung: 20.05.2015
(73) Patentinhaber: Micronas GmbH, 79108 Freiburg (DE)
(72) Erfinder: Cornils, Martin, 79098 Freiburg (DE); Sander, Christian, 79106 Freiburg (DE)
(74) Vertreter: Koch Müller Patentanwaltsgesellschaft mbH

(56) Entgegenhaltungen:
- DE-A1-102011 107 767
- DE-A1-102011 115 566
- DE-A1-102012 221 009
- DE-C1- 10 150 955
- US-A1- 2005 230 770
- US-A1- 2013 021 026

## Beschreibung

Die Erfindung betrifft eine Hallsensorvorrichtung gemäß dem Oberbegriff des Patentanspruchs 1.

Aus der DE 101 50 955 C1 ist ein Magnetfeldsensor bekannt. Der Magnetfeldsensor weist mehrere vertikale Hallsensoren mit jeweils fünf Anschlusskontakten auf. Hierbei sind die bis zu vier Hallsensoren parallel zueinander ausgebildet und die Anschlusskontakte mittels einer zyklischen Vertauschung miteinander verschaltet, um den Offset des Magnetfeldsensors im Vergleich zu dem Offset eines einzelnen Hallsensors zu verringern. Zusätzlich lässt sich der Offset mittels der sogenannten "Spinnig-Current" Methode weiter verringern. Es ist wünschenswert, die aufwändige Anordnung und die Empfindlichkeit der Magnetfeldsensoren zu verbessern.

Des Weiteren ist aus der DE 10 2011 107 767 A1 eine Hallsensorvorrichtung mit mehreren einzelnen Hallelementen bekannt. Hierbei sind die einzelnen Hallelemente der jeweiligen Hallsensorvorrichtung in einer ringförmigen Reihenschaltung verbunden. Auch aus der DE 10 2012 221 009 A, der DE 10 2011 115 566 A1 der US 2013 /021026 und der US 2005/230 770 A1 sind Hallsensoren bekannt.

Vor diesem Hintergrund besteht die Aufgabe der Erfindung darin, eine Vorrichtung anzugeben, die den Stand der Technik weiterbildet.

Die Aufgabe wird durch eine Hallsensorvorrichtung mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine auf einem Halbleiterkörper ausgebildete Hallsensorvorrichtung bereitgestellt, aufweisend einen ersten Hallsensor und einen zweiten Hallsensor, wobei jeder der beiden Hallsensoren wenigstens vier einzelne Hallelemente aufweist und die vier Hallelemente in einer Reihenschaltung verschaltet sind, und wobei jedes Hallelement drei in einer Reihe angeordnete Anschlusskontakte aufweist, und wobei der mittlere Anschlusskontakt unmittelbar benachbart zwischen den beiden äußeren Anschlusskontakten angeordnet ist, und die Reihenschaltung durch eine Zusammenschaltung oder Verschaltung der jeweils äußeren Anschlusskontakte ausgebildet ist und wobei der Anfang und das Ende der Reihenschaltung miteinander kurzgeschlossen ist und wobei die Hallelemente jeweils in einem Halbleiterwannengebiet von einem ersten Leitfähigkeitstyp ausgebildet sind, und wobei die Halbleiterwannengebiete der einzelnen Hallelemente voneinander getrennt sind, und wobei der erste Hallsensor und der zweite Hallsensor parallel verschaltet sind, in dem jeweils ein mittlerer Anschlusskontakt eines Hallelements des ersten Hallsensors mit einem mittleren Anschlusskontakt eines Hallelementes des zweiten Hallsensors verschaltet ist und jedem der verschalteten mittleren Anschlusskontakten ein Hallkontakt zugeordnet ist und an die Hallkontakte entweder eine Versorgungsspannung anlegbar oder eine Hallspannung abgreifbar ist. Es sei angemerkt, dass die in einer Reihe angeordneten Anschlusskontakte eines jeden Hallelements vorzugsweise auf einer Gerade liegen. Es versteht sich, dass unterhalb der Anschlusskontakte flache hochdotierte Anschlussgebiete ebenfalls des ersten Leitfähigkeitstyps ausgebildet sind und die Halbleiterwanne umgeben von einem Isolationsgebiet oder einem Gebiet eines zweiten Leitfähigkeitstyps ist. Es sei angemerkt, dass jedes der Hallelemente für sich alleine ein funktionsfähiges Hallelement darstellt, wobei an dem jeweiligen mittleren Anschlusskontakt eine Hallspannung messbar ist.

Ein Vorteil der erfindungsgemäßen Vorrichtung ist es, dass durch die erfindungsgemäße Verschaltung von einzelnen Hallelementen das Verhältnis von Signal zu Offsetspannung der Hallsensorvorrichtung erhöht wird, indem sich die Offsetspannungen durch die Parallelschaltung von den Hallelementen der Hallsensoren wesentlich verringern. Die Hallsensoren werden zueinander parallel verschaltet und die einzelnen Offsetspannungen kompensieren sich fast vollständig. Es versteht sich, dass die Hallelemente der Hallsensorvorrichtung eine stromdurchflossene Fläche aufweisen, wobei der Normalenvektor der Fläche parallel zu der Richtung der die Fläche durchdringenden magnetischen Feldlinien ausgebildet ist. Des Weiteren sei ausgeführt, dass die Hallkontakte nur den mittleren Anschlusskontakten zugeordnet sind und keiner der mittleren Anschlusskontakte gegenüber einem anderen benachbarten mittleren Anschlusskontakt ausgezeichnet ist, so dass sich an jedem der mittleren Anschlusskontakte eine Versorgungsspannung anlegen oder eine Hallspannung abgreifen lässt.

In einer Weiterbildung sind zwei der mittleren Anschlusskontakte der Hallelemente als Hallspannungsabgriffe und zwei der mittleren Anschlusskontakte der Hallelemente als Versorgungsspannungsanschlüsse ausgebildet. Des Weiteren weisen die Hallelemente entlang der Längserstreckung der Hallelemente vorzugsweise unterhalb der Leiterbahnebene eine identische Querschnittsstruktur auf, wobei die Längserstreckung parallel zu den drei in einer Reihe angeordneten Anschlusskontakten ausgebildet ist. Vorzugsweise sind die Anschlusskontakte von jedem Hallelement entlang einer Geraden angeordnet.

In einer anderen Weiterbildung weisen die Hallelemente des ersten Hallsensors und die Hallelemente des zweiten Hallsensors eine zwischen den beiden Hallsensoren liegende Schwerpunktsachse oder Symmetrieachse auf, wobei zwei Halielemente eines jeden Hallsensors den gleichen Abstand zu der Schwerpunktsachse oder Symmetrieachse aufweisen. In einer weiteren Ausführungsform weisen alle Hallelemente von wenigstens einem der Hallsensoren einen gleichen Abstand zu der Schwerpunktsachse oder Symmetrieachse auf. Ferner ist es bevorzugt, dass der erste Hallsensor genau die gleiche Anzahl von Hallelementen aufweist wie der zweite Hallsensor. Hierbei sind die Hallelemente vorzugsweise jeweils als vertikale Hallelemente ausgebildet. Ferner sei angemerkt, dass in einer Ausführungsform jeder der Hallsensoren mehr als vier Hallelemente aufweist und vorzugsweise die Hallsensoren jeweils die gleiche Anzahl von Hallelementen aufweisen.

In einer bevorzugten Ausführungsform sind zwischen dem ersten Hallsensor und dem zweiten Hallsensor jeweils ausschließlich nur die mittleren Anschlusskontakte miteinander verschaltet, d.h. die äußeren Kontakte eines jeden Hallsensors sind nur in dem jeweiligen Hallsensor miteinander verschaltet, so dass durch die Verbindung der jeweiligen äußeren Kontakte ein geschlossener Ring der in einer Reihenschaltung verbundenen Elemente entsteht.

In einer anderen Ausführungsform ist auf dem Halbleiterkörper der 5 Hallsensorvorrichtung zusätzlich eine integrierte Schaltung ausgebildet, wobei vorzugsweise die integrierte Schaltung mit den Hallsensoren, also vorliegend mit dem ersten. Hallsensor und dem zweiten Hallsensor, in einer elektrischen Wirkverbindung steht. Vorzugsweise ist die integrierte Schaltung ausgebildet, sowohl die Versorgungsspannungen an ausgewählten ersten mittleren Kon) takten anzulegen als auch gleichzeitig eine Hallspannung an zweiten ausgewählten mittleren Kontakten abzugreifen und auszuwerten.

Es ist des Weiteren bevorzugt, dass auf dem Halbleiterkörper ein dritter Hallsensor und ein vierter Hallsensor ausgebildet sind und dass alle vier Hallsensoren miteinander in einer elektrischen Wirkverbindung stehen, insbesondere sind die mittleren Anschlusskontakte der Hallsensoren miteinander verschaltet. Es sei hierbei angemerkt, dass unter dem Begriff Wirkverbindung unter anderem insbesondere eine elektrische Verbindung zwischen der integrierten Schaltung und dem Hallsensor oder den Hallsensoren zu verstehen ist. Ferner ist es vorteilhaft, dass der Halbleiterkörper mit den Hallsensoren und / oder der integrierten Schaltung in einem einzigen gemeinsamen Gehäuse angeordnet ist. Es sei angemerkt, dass die integrierte Schaltung vorzugsweise eine Multiplexschaltung umfasst, um die ersten beiden ausgewählten mittleren Kontakte in einem ersten Schaltzustand der Multiplexschaltung mit einer Versorgungsspannung zu beaufschlagen, während an den ausgewählten beiden zweiten mittleren Kontakten die anliegende Hallspannung abgegriffen wird. In einem zweiten Schaltzustand der Multiplexschaltung sind die zweiten beiden ausgewählten mittleren Kontakte mit einer Versorgungsspannung beaufschlagt, während an den ersten beiden ausgewählten mittleren Kontakten die anliegende Hallspannung abgegriffen wird. Insbesondere lässt sich mit der Multiplexereinheit auch ein sogenanntes "Spinning Current" Verfahren durchführen um die Offsetspannungen der Hallsensorvorrichtung weiter zu reduzieren.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. Abstände und laterale und vertikale Erstreckungen sind nicht maßstäblich und weisen, sofern nicht anders angegeben, auch keine ableitbare geometrische Relation zueinander auf. Darin zeigt die:
- Figur 1: eine schematische Draufsicht auf eine erfindungsgemäße Ausführungsform einer Hallsensorvorrichtung mit genau zwei Hallsensoren mit jeweils vier Hallelementen in einer ersten diagonalen Verschaltungskonfiguration,
- Figur 2: eine schematische Draufsicht auf eine erfindungsgemäße Ausführungsform einer Hallsensorvorrichtung mit genau vier Hallsensoren mit jeweils vier Hallelementen in der ersten diagonalen Verschaltungskonfiguration,
- Figur 3: eine schematische Draufsicht auf eine erfindungsgemäße Ausführungsform einer Hallsensorvorrichtung mit genau vier Hallsensoren mit jeweils vier Hallelementen in einer zweiten Verschaltungskonfiguration,
- Figur 4: eine schematische Draufsicht auf eine erfindungsgemäße Ausführungsform einer Hallsensorvorrichtung mit mehr als vier Hallsensoren, wobei jeder Hallsensor genau vier Hallelemente aufweist in der zweiten Verschaltungskonfiguration,
- Figur 5: eine schematische Draufsicht auf eine erfindungsgemäße Ausführungsform einer Hallsensorvorrichtung mit vier Hallsensoren, wobei jeder Hallsensor mehr als vier Hallelemente aufweist in der ersten Verschaltungskonfiguration,
- Figur 6: eine schematische Draufsicht auf eine erfindungsgemäße Ausführungsform einer Hallsensorvorrichtung mit genau vier Hallsensoren mit jeweils vier Hallelementen in der ersten Verschaltungskonfiguration, jedoch mit einer ersten gruppenförmigen Anordnung der Hallelemente,
- Figur 7: eine schematische Draufsicht auf eine erfindungsgemäße Ausführungsform einer Hallsensorvorrichtung mit genau vier Hallsensoren mit jeweils vier Hallelementen in der ersten Schaltungskonfiguration, jedoch mit einer zweiten gruppenförmigen Anordnung der Hallelemente
- Figur 8a: eine Auftragung der Einzelphasen-Offsetspannung in Abhängigkeit des Betriebsstroms des Hallsensors,
- Figur 8b: eine Auftragung der verbleibenden Offsetspannung nach Anwendung der "Spinning-Current" Methode in Abhängigkeit der Anzahl der gemessenen erfindungsgemäßen Vorrichtungen.

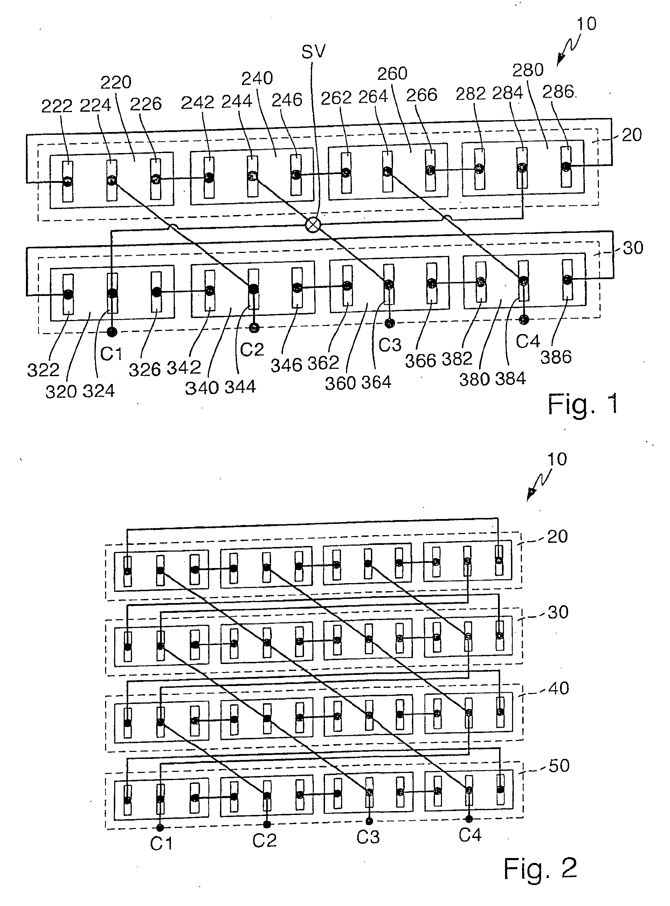

Die Abbildung der Figur 1 zeigt eine schematische Draufsicht auf eine erfindungsgemäße Ausführungsform einer Hallsensorvorrichtung 10 mit einem ersten Hallsensor 20 und einem zweiten Hallsensor 30 in einer ersten Verschaltungskonfiguration.

Der erste Hallsensor 20 weist ein erstes Hallelement 220, ein zweites Hallelement 240, ein drittes Hallelement 260 und ein viertes Hallelement 280 auf, wobei das erste Hallelement 220 einen ersten äußeren Anschlusskontakt 222 und einen zweiten mittleren Anschlusskontakt 224 und einen dritten äußeren Anschlusskontakt 226 umfasst, d.h. der zweite Anschlusskontakt 224 ist unmittelbar benachbart von dem ersten Anschlusskontakt 222 und von dem dritten Anschlusskontakt 226. Ferner umfasst das zweite Hallelement 240 einen ersten äußeren Anschlusskontakt 242 und einen zweiten mittleren Anschlusskontakt 244 und einen dritten äußeren Anschlusskontakt 246, d.h. der zweite Anschlusskontakt 244 ist unmittelbar benachbart von dem ersten Anschlusskontakt 242 und von dem dritten Anschlusskontakt 246.

Des Weiteren umfasst das dritte Hallelement 260 einen ersten äußeren Anschlusskontakt 262 und einen zweiten mittleren Anschlusskontakt 264 und einen dritten äußeren Anschlusskontakt 266, d.h. der zweite Anschlusskontakt 264 ist unmittelbar benachbart von dem ersten Anschlusskontakt 262 und von dem dritten Anschlusskontakt 266. Schließlich umfasst das vierte Hallelement 280 einen ersten äußeren Anschlusskontakt 282 und einen zweiten mittleren Anschlusskontakt 284 und einen dritten äußeren Anschlusskontakt 286, d.h. der zweite Anschlusskontakt 284 ist unmittelbar benachbart zu dem ersten Anschlusskontakt 282 und zu dem dritten Anschlusskontakt 286.

Die vier Hallelemente 220, 240, 260 und 280 des ersten Hallsensors 20 sind in einer ringförmig geschlossen Reihenschaltung untereinander verbunden. Hierbei ist der dritte Anschlusskontakt 226 des ersten Hallelements 220 mit dem ersten Anschlusskontakt 242 des zweiten Hallelements 240 und der dritte Anschlusskontakt 246 des zweiten Hallelements 240 mit dem ersten Anschlusskontakt 262 des dritten Hallelements 260 und dritte Anschlusskontakt 266 des dritten Hallelements 260 mit dem ersten Anschlusskontakt 282 des vierten Hallelements 280 und dritte Anschlusskontakt 286 des vierten Hallelements 280 mit dem ersten Anschlusskontakt 222 des ersten Hallelements 220 verschaltet.

Ferner ist der zweite Anschlusskontakt 224 des ersten Hallelements 220 als ein zweiter Hallkontakt C2 und der zweite Anschlusskontakt 244 des zweiten Hallelements als ein dritter Hallkontakt C3 und der zweite Anschlusskontakt 264 des dritten Hallelements 260 als eine vierter Hallkontakt C4 und der zweite Anschlusskontakt 284 des vierten Hallelements 280 als ein erster Hallkontakt C1 des ersten Hallsensors 20 ausgebildet.

Der zweite Hallsensor 30 weist ein erstes Hallelement 320, ein zweites Hallelement 340, ein drittes Hallelement 360 und ein viertes Hallelement 380 auf, wobei das erste Hallelement 320 einen ersten äußeren Anschlusskontakt 322 und einen zweiten mittleren Anschlusskontakt 324 und einen dritten äußeren Anschlusskontakt 326 umfasst, d.h. der zweite Anschlusskontakt 324 ist unmittelbar benachbart von dem ersten Anschlusskontakt 322 und von dem dritten Anschlusskontakt 326. Ferner umfasst das zweite Hallelement 5 340 einen ersten äußeren Anschlusskontakt 342 und einen zweiten mittleren Anschlusskontakt 344 und einen dritten äußeren Anschlusskontakt 346, d.h. der zweite Anschlusskontakt 344 ist unmittelbar benachbart von dem ersten Anschlusskontakt 342 und von dem dritten Anschlusskontakt 346.

Des Weiteren umfasst das dritte Hallelement 360 des zweiten Hallsensors 30 einen ersten äußeren Anschlusskontakt 362 und einen zweiten mittleren Anschlusskontakt 364 und einen dritten äußeren Anschlusskontakt 366, d.h. der zweite Anschlusskontakt 364 ist unmittelbar benachbart von dem ersten Anschlusskontakt 362 und von dem dritten Anschlusskontakt 366. Schließlich umfasst das vierte Hallelement 380 einen ersten äußeren Anschlusskontakt 382 und einen zweiten mittleren Anschlusskontakt 384 und einen dritten äußeren Anschlusskontakt 386, d.h. der zweite Anschlusskontakt 384 ist unmittelbar benachbart von dem ersten Anschlusskontakt 382 und von dem dritten Anschlusskontakt 386.

Die vier Hallelemente 320, 340, 360 und 380 des zweiten Hallsensors 30 sind in einer ringförmig geschlossen Reihenschaltung untereinander verbunden. Hierbei ist der dritte Anschlusskontakt 326 des ersten Hallelements 320 mit dem ersten Anschlusskontakt 342 des zweiten Hallelements 340 und der dritte Anschlusskontakt 346 des zweiten Hallelements 340 mit dem ersten Anschlusskontakt 362 des dritten Hallelements 360 und dritte Anschlusskontakt 366 des dritten Hallelements 360 mit dem ersten Anschlusskontakt 382 des vierten Hallelements 380 und dritte Anschlusskontakt 386 des vierten Hallelements 380 mit dem ersten Anschlusskontakt 322 des ersten Hallelements 320 verschaltet.

Ferner ist der zweite Anschlusskontakt 324 des ersten Hallelements 320 mit dem ersten Hallkontakt C1 und der zweite Anschlusskontakt 344 des zweiten Hallelements mit dem zweiten Hallkontakt C2 und der zweite Anschlusskontakt 364 des dritten Hallelements 360 mit dem dritten Hallkontakt C3 und der zweite Anschlusskontakt 384 des vierten Hallelements 380 mit dem vierten Hallkontakt C4 verschaltet.

Ferner ist der zweite Anschlusskontakt 224 des ersten Hallelements 220 des ersten Hallsensors 20 mit dem zweiten Anschlusskontakt 344 des zweiten Hallelements 340 des zweiten Hallsensors 30 und der zweite Anschlusskontakt 244 des zweiten Hallelements 240 des ersten Hallsensors 20 mit dem dritten Anschlusskontakt 366 des dritten Hallelements 360 des zweiten Hallsensors 30 und der zweite Anschlusskontakt 264 des dritten Hallelements 260 des ersten Hallsensors 20 mit dem zweiten Anschlusskontakt 384 des vierten Hallelements 380 des zweiten Hallsensors 30 und der zweite Anschlusskontakt 284 des vierten Hallelements 280 des ersten Hallsensors 20 mit dem zweiten Anschlusskontakt 324 des ersten Hallelements 320 des zweiten Hallsensors 30 verschaltet. Zwischen den beiden Hallsensoren ist eine Symmetrieachse SV ausgebildet.

Des Weiteren ist jedes der Hallelemente 220, 240, 260, 280, 320, 340, 360 und 380 als vertikales Hallelement jeweils in einem eigenen Halbleiterwannengebiet, nicht dargestellt, von einem ersten Leitfähigkeitstyp ausgebildet, wobei die Halbleiterwannengebiete der einzelnen Hallelemente 220, 240, 260, 280, 320, 340, 360 und 380 voneinander durch ein Isolationsgebiet getrennt sind. Vorteilhafterweise ist der erste Leitfähigkeitstyp als n-Dotierung ausgebildet.

Indem die mittleren Anschlusskontakte 224, 244, 264 und 284 des ersten Hallsensors 20 mit den mittleren Anschlusskontakten 324, 344, 364 und 384 jeweils paarweise verschaltet sind und insbesondere jeweils mit einem Hallkontakt C1 oder C2 oder C3 oder C4 verbunden sind, ist der erste Hallsensor 20 mit dem zweiten Hallsensor 30 parallelgeschaltet.

Ein Vorteil ist, dass sich durch die Parallelschaltung von mehreren Hallsensoren 20 und 30 die Offsetspannung wesentlich reduzieren lässt. Es versteht sich, dass zwei der Hallkontakte C1, C2, C3 und C4 als Versorgungsspannungsanschlüsse ausgeführt sind, d. h. mit einer Versorgungsspannung beaufschlagbar sind und an den zwei verbleibenden Hallkontakten C1, C2, C3 und C4 eine Hallspannung abgreifbar ist. Hierbei ist eine Mehrzahl von unterschiedlichen Schaltungsvarianten durchführbar, anders ausgedrückt die Versorgungsspannung lässt sich an unterschiedliche Hallkontakte C1, C2, C3 und C4 anlegen und entsprechend lässt sich die Hallspannung an den anderen Hallkontakten C1, C2, C3 und C4 abgreifen.

In der Abbildung der Figur 2 ist eine weitere erfindungsgemäße Ausführungsform einer Hallsensorvorrichtung 10 mit mehreren Hallsensoren mit jeweils vier Hallelementen in der ersten diagonalen Verschaltungskonfiguration dargestellt. Im Folgenden werden nur die Unterschiede zu der Ausführungsform in der Abbildung der Figur 1 erläutert. Aus Gründen der Übersichtlichkeit ist die detaillierte Referenzierung der einzelnen Hallelemente, dargestellt in der Abbildung der Fig. 1, nicht angeführt und die Referenzierung ist auch nicht weiter fortgeführt. Zu dem ersten Hallsensor 20 und dem zweiten Hallsensor 30 sind nunmehr ein dritter Hallsensor 40 und ein vierter Hallsensor 50 parallelgeschaltet, indem wiederum die mittleren Anschlusskontakte der einzelnen Hallelemente miteinander verschaltet sind. Hierbei wird die diagonale Verschaltung der mittleren Anschlusskontakte der beiden Hallsensoren 20 und 30 der Ausführungsform der Figur 1 weitergeführt, d. h. auch bei dem dritten Hallsensor 40 und dem vierten Hallsensor 50 sind die mittleren Kontakte von Hallsensor 20, 30, 40 und 50 zu Hallsensor 20, 30, 40 und 50 in der diagonalen Verschaltungsanordnung zusammengeschaltet. Hierdurch sind mit jedem der Hallkontakte C1 bis C4 jeweils genau vier mittlere Anschlusskontakte von vier Hallelementen von den vier Hallsensoren 20, 30, 40 und 50 zusammengeschaltet.

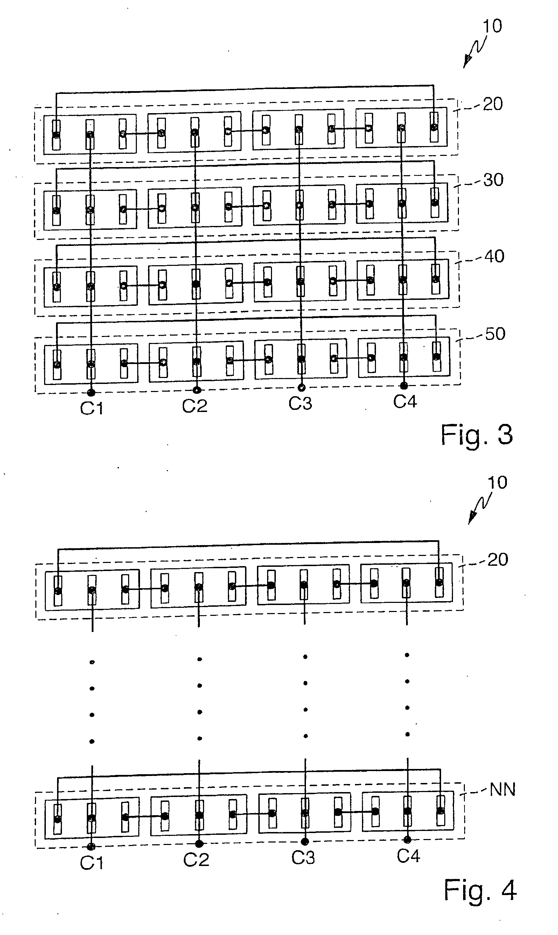

In der Abbildung der Figur 3 ist eine weitere erfindungsgemäße Ausführungsform einer Hallsensorvorrichtung 10 mit vier Hallsensoren 20, 30, 40 und 50 und mit vier Hallelementen je Hallsensor 20, 30, 40 und 50 in einer zweiten geraden Verschaltungskonfiguration dargestellt. Im Folgenden werden nur die Unterschiede zu der Ausführungsform, dargestellt in der Abbildung der Figur 2, erläutert. Die jeweiligen ersten mittleren Anschlusskontakte der vier Hallsensoren 20, 30, 40 und 50 sind miteinander und mit dem ersten Hallkontakt C1 verschaltet, und die jeweiligen zweiten mittleren Anschlusskontakte der vier Hallsensoren 20, 30, 40 und 50 sind miteinander und mit dem zweiten Hallkontakt C2 verschaltet, sowie die jeweiligen dritten mittleren An-5 schlusskontakte der vier Hallsensoren 20, 30, 40 und 50 sind miteinander und mit dem dritten Hallkontakt C3 verschaltet und die jeweiligen vierten mittleren Anschlusskontakte der vier Hallsensoren 20, 30, 40 und 50 sind miteinander und mit dem vierten Hallkontakt C4 verschaltet.

In der Abbildung der Figur 4 ist eine weitere erfindungsgemäße Ausführungsform einer Hallsensorvorrichtung 10 mit einer Vielzahl von größer als vier der Hallsensoren 20, 30, 40 und 50 mit vier Hallelementen je Hallsensor 20, 30, 40 und 50 in der zweiten geraden Verschaltungskonfiguration dargestellt. Im Folgenden werden nur die Unterschiede zu der Ausführungsform, dargestellt in der Abbildung der Figur 3, erläutert. Zusätzlich zu den vier Hallsensoren 20, 30, 40 und 50 ist nunmehr eine Vielzahl von Hallsensoren bis zu einer Anzahl NN parallel in der zweiten geraden Verschaltungskonfiguration verschaltet. Die Anzahl NN liegt vorzugsweise oberhalb von fünf, höchst vorzugsweise oberhalb von zehn Hallsensoren. Es versteht sich, dass sich auch die Vielzahl von den parallel verschalteten Hallsensoren alternativ zu der zweiten geraden Verschaltungskonfiguration in der ersten diagonalen Verschaltungskonfiguration verschalten lässt.

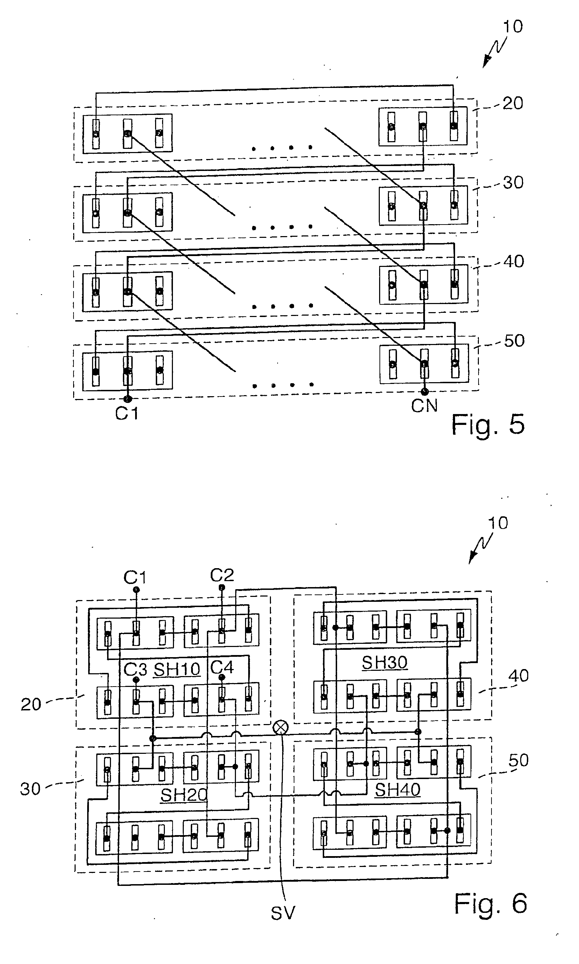

In der Abbildung der Figur 5 ist eine weitere erfindungsgemäße Ausführungsform einer Hallsensorvorrichtung 10 mit vier Hallsensoren 20, 30, 40 und 50 jedoch mit jeweils mehr als vier Hallelementen je Hallsensor 20, 30, 40 und 50 in der ersten diagonalen Schaltungskonfiguration dargestellt. Im Folgenden werden nur die Unterschiede zu der Ausführungsform, in Zusammenhang mit der Abbildung der Figur 2 dargestellt, erläutert. Zusätzlich zu den vier Hallelementen weist jeder der Hallsensoren 20, 30, 40 und 50 nunmehr eine Vielzahl von zusätzlichen Hallelementen auf. Entsprechend der zusätzlichen Anzahl der Hallelemente ist auch die Anzahl der Hallkontakte bis zu einer Anzahl N erhöht, Vorliegend sind die Hallsensoren 20, 30, 40 und 50 parallel in der ersten diagonalen Verschaltungskonfiguration und mit dem jeweiligen Hallkontakt C1 bis CN verbunden. Die Anzahl der Hallkontakte je Hallsensor 20, 30, 40 und 50, der in der vorgenannten Reihenschaltung verbundenen Hallelemente, liegt vorzugsweise oberhalb von fünf, höchst vorzugsweise oberhalb von zehn Hallelementen. Es versteht sich, dass sich auch die Vielzahl von den parallel verschalteten Hallsensoren alternativ zu der ersten diagonalen Verschaltungskonfiguration auch in der zweiten geraden Verschaltungskonfiguration verschalten lässt.

In der Abbildung der Figur 6 ist eine weitere erfindungsgemäße Ausführungs) form einer Hallsensorvorrichtung 10 mit vier Hallelementen je Hallsensor 20, 30, 40 und 50 in einer dritten gruppierten Verschaltungskonfiguration dargestellt. Im Folgenden werden nur die Unterschiede zu der Ausführungsform, dargestellt in der Abbildung der Figur 3, erläutert. Der jeweilige Hallsensor 20, 30, 40 und 50 ist in zwei untereinander liegende Reihen aufgeteilt, wobei jeder Hallsensor 20, 30, 40 und 50 jeweils in einem der vier dargestellten Vierecke ausgebildet ist. Des Weiteren weist jeder Hallsensor 20, 30, 40 und 50 eine in der Mitte des jeweiligen Hallsensors 20, 30, 40 und 50 liegende Sensorschwerpunktsachse SH10, SH20, SH30, und SH40 auf. Die Sensorschwerpunktsachsen SH10, SH20, SH30, und SH40 weisen bezüglich einer gemeinsamen Schwerpunktsachse bzw. Symmetrieachse SV der Hallsensorvorrichtung 10 jeweils den gleichen Abstand auf. Entsprechend der gruppierten Anordnung der einzelnen Hallsensoren 20, 30, 40 und 50 sind die Hallkontakte C1, C2, C3 und C4 auch in zwei untereinander liegenden Reihen gruppiert. Es versteht sich dass die mittleren Anschlusskontakte der Hallelemente der einzelnen Hallsensoren 20, 30, 40 und 50 derart miteinander verschaltet sind, dass die Hallsensoren 20, 30, 40 und 50 jeweils bezüglich der Hallkontakte C1, C2, C3 und C4 parallel verschaltet sind und hinsichtlich der Symmetrieachse SV jedes der vier mit einem der Hallkontakte C1, C2, C3 und C4 verschalteten Hallelemente der Hallsensoren 20, 30, 40 und 50 den gleichen Abstand zu der Symmetrieachse SV aufweist.

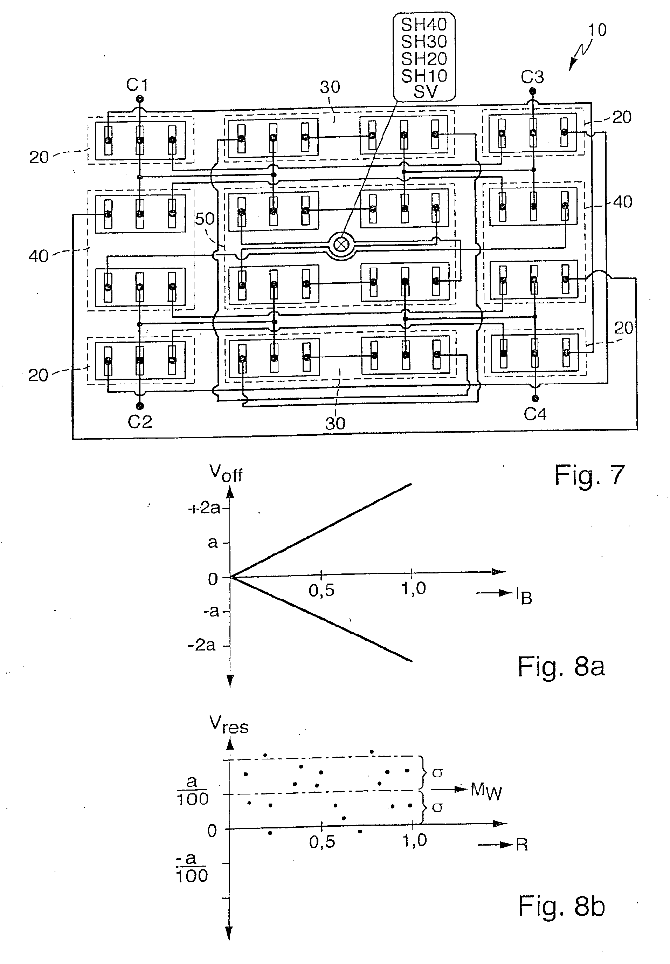

In der Abbildung der Figur 7 ist eine weitere erfindungsgemäße Ausführungsform einer Hallsensorvorrichtung 10 mit vier Hallelementen je Hallsensor 20, 30, 40 und 50 in einer vierten, unterteilten Verschaltungskonfiguration dargestellt. Die Hallsensorvorrichtung bildet ein Viereck aus. Im Folgenden werden nur die Unterschiede zu der Ausführungsform, dargestellt in der Abbildung der Figur 6, erläutert. Bei jedem der vier Hallsensoren 20, 30, 40 und 50 ist immer eines der vier Hallelemente eines jeden Hallsensors 20, 30, 40 5 und 50 in einem Quadranten des Vierecks angeordnet. Es versteht sich, dass die vier Hallelemente eines jeden Hallsensors 20, 30, 40 und 50 trotz der verteilten Anordnung in der vorgenannten Reihenverschaltung verbunden sind. Hierbei sind die einzelnen Hallelemente eines jeden der Hallsensoren 20, 30, 40 und 50 derart verteilt, dass jedes der vier Hallelementen bezüglich der gemeinsamen Schwerpunktsachse bzw. Symmetrieachse SV der Hallsensorvorrichtung 10 denselben Abstand zu der Symmetrieachse SV aufweist. Ferner sind immer zwei Hallelemente des jeweiligen Hallsensors 20, 30, 40 und 50 spiegelsymmetrisch zueinander bezüglich der Symmetrieachse SV angeordnet und weisen den gleichen Abstand zu der Symmetrieachse SV auf. Ferner fallen die einzelnen Sensorschwerpunktachsen SH10, SH20, SH30 und SH40 mit der Symmetrieachse SV zusammen. Im Unterschied zu Fig. 6 sind die mittleren Anschlusskontakte der Hall-Elemente innerhalb eines jeden Quadranten des Vierecks miteinander verbunden und jeweils mit einem der vier Hall-Kontakte C1, C2, C3, und C4 verbunden.

Ein Vorteil der Verteilung der Hallelemente ist, dass der Einfluss einer statischen Divergenz der magnetischen Flussdichte in dem Gebiet der Hallsensorvorrichtung 10 stark unterdrückt wird. Hierdurch lässt sich die Offsetspannung der Hallsensorvorrichtung 10 weiter verringern.

Es sei darauf hingewiesen, dass im Unterschied zu den dargestellten Ausführungsformen der Hallelemente, die Hallelemente in Abweichung zu der auf einer Geraden angeordneten Anordnung der Anschlusskontakte auch eine gegeneinander versetzte Anordnung der Anschlusskontakte aufweisen können. Hierdurch sind die Anschlusskontakte der Hallsensoren 20, 30 40 und 50 nicht mehr auf einer Geraden angeordnet. Trotzdem weisen die einzelnen Hallelemente ein identisches strukturelles Layout derart auf, dass unterhalb der Leiterbahnebene bei einem Querschnitt entlang der reihenförmigen Anordnung der Anschlusskontakte die jeweilige Ausbildung der Hallelemente zueinander ununterscheidbar ist. Auch lassen sich die einzelnen Hallelemente in Abweichung der vorliegenden zueinander parallelen ausgebildeten Anordnung der jeweiligen Geraden der Anschlusskontakte auch zueinander verdreht ausbilden, sodass die durch die Reihen der Anschlusskontakte verlaufenden Geraden von Hallelement zu Hallelement einen Winkel zueinander aufweisen, d.h. die Hallelemente sind zueinander nicht gleichsinnig ausgerichtet. Untersuchungen haben gezeigt, dass die Größe der Offsetspannung hiervon nicht abhängig ist.

In der Abbildung der Figur 8a sind die Offsetspannungen VOFF über der Größe des Betriebsstroms IB der Hallsensorvorrichtung 10 aufgetragen. Die Figur 8a zeigt hierbei den Verlauf der Offsetspannung VOFF, je nach Verwendung der Hall Kontakte C1, C2, C3, C4 gemäß Spinning Current Verfahren. Für beide Verläufe der Offsetspannung VOFF gilt, dass die Offsetspannung VOFF mit zunehmender Größe des Betriebsstromes IB betragsmäßig größer wird und die Achsenabschnitte a oder -a übersteigt

Darüber hinaus zeigt Fig. 8b den residualen Offset Vres nach Durchführung des Spinning Current Verfahrens für eine Vielzahl von Hallsensorvorrichtungen 10, die auf einem Wafer ausgebildet sind. Entlang der Y-Achse sind die verbleibenden Offsetspannungen Vres aufgetragen, wobei entlang der X-Achse die gemessenen Hallsensorvorrichtungen aufgetragen sind. Gemäß der Abbildung der Figur 8b entspricht jeder Punkt der gemessenen Offsetspannung einer der Hallsensorvorrichtungen. Es sei darauf hingewiesen, dass gegenüber der Darstellung in der Figur 8a die Skalierung der Y-Achse um den Faktor 100 gespreizt abgebildet ist, um überhaupt noch eine Offsetspannung darstellen zu können. Hiernach lassen sich mit der erfindungemäßen Hallsensorvorrichtung die Offsetspannungen extrem stark verringern und somit der Messbereich zu geringen Magnetfeldstärken stark erhöhen. Anders ausgedrückt, weist die Hallsensorvorrichtung einen erhöhten Dynamikumfang auf.

Des Weiteren zeigt sich, dass auch die Streuung der Offsetspannungen zwischen den Hallsensorvorrichtungen sehr klein ist. So ergibt sich aus einer Vielzahl von Messungen der Offsetspannungen von verschiedenen Hallsensorvorrichtungen, dass die Standardabweichungen δ und - 5 nur sehr klein ist, d. h. bei über 90% der gemessenen Hallsensorvorrichtungen liegt die gemessene Offsetspannung VOFF sehr nahe an dem Mittelwert MW.

## Patentansprüche

1. Hallsensorvorrichtung (10) auf einem Halbleiterkörper ausgebildet, mit - einem ersten Hallsensor (10) und einem zweiten Hallsensor (20), wobei jeder Hallsensor (10, 20) wenigstens vier einzelne Hallelemente aufweist (220, 240, 260, 280, 320, 340, 360, 380) und die vier Hallelemente (220, 240, 260, 280, 320, 340, 360, 380) in einer Reihenschaltung verschaltet sind, und wobei jedes Hallelement (220, 240, 260, 280, 320, 340, 360, 380) drei in einer Reihe angeordnete Anschlusskontakte (222, 224, 226, 242, 244, 246, 262, 264, 266, 282, 284, 286, 322, 324, 326, 342, 344, 346, 362, 364, 366, 382, 384, 386) aufweist, wobei der mittlere Anschlusskontakt (224, 244, 264, 284, 324, 344, 364, 384) unmittelbar benachbart zwischen den beiden äußeren Anschlusskontakten (222, 226, 242, 246, 262, 266, 282, 286, 322, 326, 342, 346, 362, 366, 382, 386) angeordnet ist, und die Reihenschaltung mittels einer Verschaltung der jeweils äußeren Anschlusskontakte (222, 226, 242, 246, 262, 266, 282, 286, 322, 326, 342, 346, 362, 366, 382, 386) ausgebildet ist und wobei der Anfang und das Ende der Reihenschaltung miteinander kurzgeschlossen ist und wobei die Hallelemente (220, 240, 260, 280, 320, 340, 360, 380) jeweils in einem Halbleiterwannengebiet von einem ersten Leitfähigkeitstyp ausgebildet sind, wobei die Halbleiterwannengebiete der einzelnen Hallelemente (220, 240, 260, 280, 320, 340, 360, 380) voneinander getrennt sind, **gekennzeichnet dadurch dass** der erste Hallsensor (20) und der zweite Hallsensor (30) parallel verschaltet sind, in dem jeweils ein mittlerer Anschlusskontakt (224, 244, 264, 284) eines Hallelements (220, 240, 260, 280) des ersten Hallsensors (20) mit einem mittleren Anschlusskontakt (324, 344, 364, 384) eines Hallelementes (320, 340, 360, 380) des zweiten Hallsensors (30) verschaltet ist und jedem der verschalteten mittleren Anschlusskontakte (224, 244, 264, 284, 324, 344, 364, 384) ein Hallkontakt (C1, C2, C3, C4) zugeordnet ist und an den Hallkontakten (C1, C2, C3, C4) entweder eine Versorgungsspannung anlegbar oder eine Hallspannung abgreifbar ist.

2. Hallsensorvorrichtung (10) nach Anspruch 1, **dadurch gekennzeichnet, dass** zwei der mittleren Anschlusskontakte (224, 244, 264, 284, 324, 344, 364, 384) der Hallelemente (220, 240, 260, 280, 320, 340, 360, 380) als Hallspannungsabgriffe und zwei der mittleren Anschlusskontakte (224, 244, 264, 284, 324, 344, 364, 384) der Hallelemente (220, 240, 260, 280, 320, 340, 360, 380) als Versorgungsspannungsanschlüsse ausgebildet sind.

3. Hallsensorvorrichtung (10) nach Anspruch 1 oder Anspruch 2, **dadurch gekennzeichnet, dass** die Hallelemente (220, 240, 260, 280, 320, 340, 360, 380) entlang der Längserstreckung der Hallelemente (220, 240, 260, 280, 320, 340, 360, 380) eine identische Querschnittsstruktur aufweisen, wobei die Längserstreckung parallel zu den drei in einer Reihe angeordneten Anschlusskontakten (222, 224, 226, 242, 244, 246, 262, 264, 266, 282, 284, 286, 322, 324, 326, 342, 344, 346, 362, 364, 366, 382, 384, 386) ausgebildet ist.

4. Hallsensorvorrichtung (10) nach einem der vorstehenden Ansprüche, **dadurch gekennzeichnet, dass** die Hallelemente (220, 240, 260, 280) des ersten Hallsensors (20) und die Hallelemente (320, 340, 360, des zweiten Hallsensors (30) eine zwischen den beiden Hallsensoren (20, 30) liegende Symmetrieachse (SV) aufweisen und zwei der Hallelemente (220, 240, 260, 280, 320, 340, 360, 380) eines jeden Hallsensors (20, 30) den gleichen Abstand zu der Symmetrieachse (SV) aufweisen.

5. Hallsensorvorrichtung (10) nach einem der vorstehenden Ansprüche, **dadurch gekennzeichnet, dass** der erste Hallsensor (20) genau die gleiche Anzahl von Hallelementen (220, 240, 260, 280, 320, 340, 360, 380) wie der zweite Hallsensor (30) aufweist.

6. Hallsensorvorrichtung (10) nach einem der vorstehenden Ansprüche, **dadurch gekennzeichnet, dass** zwischen dem ersten Hallsensor (20) und dem zweiten Hallsensor (30) jeweils nur die mittleren Anschlusskontakte (224, 244, 264, 284, 324, 344, 364, 384) miteinander verschaltet sind.

7. Hallsensorvorrichtung (10) nach einem der vorstehenden Ansprüche, **dadurch gekennzeichnet, dass** die Hallelemente (220, 240, 260, 280, 320, 340, 360, 380) jeweils als vertikale Hallelemente (220, 240, 260, 280, 320, 340, 360, 380) ausgebildet sind.

8. Hallsensorvorrichtung (10) nach einem der vorstehenden Ansprüche, **dadurch gekennzeichnet, dass** auf dem Halbleiterkörper eine integrierte Schaltung ausgebildet ist und die integrierte Schaltung mit dem ersten Hallsensor (20) und dem zweiten Hallsensor (30) in einer elektrischen Wirkverbindung steht.

9. Hallsensorvorrichtung (10) nach einem der vorstehenden Ansprüche, **dadurch gekennzeichnet, dass** jeder Hallsensor (20, 30) mehr als vier Hallelemente (220, 240, 260, 280, 320, 340, 360, 380) aufweist.

10. Hallsensorvorrichtung (10) nach einem der vorstehenden Ansprüche, **dadurch gekennzeichnet, dass** alle Hallelemente (220, 240, 260, 280, 320, 340, 360, 380) von wenigstens einem der Hallsensoren (20, 30) den gleichen Abstand zu der Symmetrieachse (SV) aufweisen.

11. Hallsensorvorrichtung (10) nach einem der vorstehenden Ansprüche, **dadurch gekennzeichnet, dass** auf dem Halbleiterkörper ein dritter Hallsensor (40) und ein vierter Hallsensor (50) ausgebildet sind und die vier Hallsensoren (20, 30, 40, 50) miteinander in einer elektrischen Wirkverbindung stehen.

12. Hallsensorvorrichtung (10) nach einem der vorstehenden Ansprüche, **dadurch gekennzeichnet, dass** der Halbleiterkörper mit den Hallsensoren (20, 30, 40, 50) in einem einzigen gemeinsamen Gehäuse angeordnet ist.

## Claims

1. Hall sensor device (10) constructed on a semiconductor body, comprising a first Hall sensor (10) and a second Hall sensor (20), wherein each Hall sensor (10, 20) comprises at least four individual Hall elements (220, 240, 260, 280, 320, 340, 360, 380) and the four Hall elements (220, 240, 260, 280, 320, 340, 360, 380) are connected in series, wherein each Hall element (220, 240, 260, 280, 320, 340, 360, 380) comprises three terminal contacts (222, 224, 226, 242, 244, 246, 262, 264, 266, 282, 284, 286, 322, 324, 326, 342, 344, 346, 362, 364, 366, 382, 384, 386) arranged in a row, wherein the middle terminal contact (224, 244, 264, 284, 324, 344, 364, 384) is arranged directly adjacent between the two outer terminal contacts (222, 226, 242, 246, 262, 266, 282, 286, 322, 326, 342, 346, 362, 366, 382, 386) and the series circuit is formed by means of a connection of the respective outer terminal contacts (222, 226, 242, 246, 262, 266, 282, 286, 322, 326, 342, 346, 362, 366, 382, 386) and wherein the start and the end of the series circuit is short-circuited together and wherein the Hall elements (220, 240, 260, 280, 320, 340, 360, 380) are each formed in a semiconductor trough region by a first conductivity type, wherein the semiconductor trough regions of the individual Hall elements (220, 240, 260, 280, 320, 340, 360, 380) are separated from one another,
**characterised in that** the first Hall sensor (20) and the second Hall sensor (30) are connected in parallel, **in that** in each instance a middle terminal contact (224, 244, 264, 284) of a Hall element (220, 240, 260, 280) of the first Hall sensor (20) is connected with a middle terminal contact (324, 344, 364, 384) of a Hall element (320, 340, 360, 380) of the second Hall sensor (30) and a Hall contact (C1, C2, C3, C4) is associated with each of the connected middle terminal contacts (224, 244, 264, 284, 324, 344, 364, 384) and either a supply voltage can be applied to or a Hall voltage can be derived from the Hall contacts (C1, C2, C3, C4).

2. Hall sensor device (10) according to claim 1, **characterised in that** two of the middle terminal contacts (224, 244, 264, 284, 324, 344, 364, 384) of the Hall elements (220, 240, 260, 280, 320, 340, 360, 380) are constructed as Hall voltage taps and two of the middle terminal contacts (224, 244, 264, 284, 324, 344, 364, 384) of the Hall elements (220, 240, 260, 280, 320, 340, 360, 380) are constructed as supply voltage terminals.

3. Hall sensor device (10) according to claim 1 or claims 2, **characterised in that** the Hall elements (220, 240, 260, 280, 320, 340, 360, 380) have an identical cross-sectional structure along the length direction of the Hall elements (220, 240, 260, 280, 320, 340, 360, 380), wherein the length direction is formed parallel to the three terminal contacts (222, 224, 226, 242, 244, 246, 262, 264, 266, 282, 284, 286, 322, 324, 326, 342, 344, 346, 362, 364, 366, 382, 384, 386) arranged in a row.

4. Hall sensor device (10) according to any one of the preceding claims, **characterised in that** the Hall elements (220, 240, 260, 280) of the first Hall sensor (20) and the Hall elements (320, 340, 360, 380) of the second Hall sensor (30) have an axis (SV) of symmetry lying between the two Hall sensors (20, 30) and two of the Hell elements (220, 240, 260, 280, 320, 340, 360, 380) of each Hall sensor (20, 30) have the same spacing from the axis (SV) of symmetry.

5. Hall sensor device (10) according to any one of the preceding claims, **characterised in that** the first Hall sensor (20) has exactly the same number of Hall elements (220, 240, 260, 280, 320, 340, 360, 380) as the second Hall sensor (30).

6. Hall sensor device (10) according to any one of the preceding claims, **characterised in that** between the first Hall sensor (20) and the second Hall sensor (30) in each instance only the middle terminal contacts (224, 244, 264, 284, 324, 344, 364, 384) are connected together.

7. Hall sensor device (10) according to any one of the preceding claims, **characterised in that** the Hall elements (220, 240, 260, 280, 320, 340, 360, 380) are each constructed as vertical Hall elements (220, 240, 260, 280, 320, 340, 360, 380).

8. Hall sensor device (10) according to any one of the preceding claims, **characterised in that** an integrated circuit is constructed on the semiconductor body and the integrated circuit is disposed in electrically operative connection with the first Hall sensor (20) and the second Hall sensor (30).

9. Hall sensor device (10) according to any one of the preceding claims, **characterised in that** each Hall sensor (20, 30) comprises more than four Hall elements (220, 240, 260, 280, 320, 340, 360, 380).

10. Hall sensor device (10) according to any one of the preceding claims, **characterised in that** all Hall elements (220, 240, 260, 280, 320, 340, 360, 380) of at least one of the Hall sensors (20, 30) have the same spacing from the axis (SV) of symmetry.

11. Hall sensor device (10) according to any one of the preceding claims, **characterised in that** a third Hall sensor (40) and a fourth Hall sensor (50) are constructed on the semiconductor body and the four Hall sensors (20, 30, 40, 50) are disposed in electrically operative connection with one another.

12. Hall sensor device (10) according to any one of the preceding claims, **characterised in that** the semiconductor body together with the Hall sensors (20, 30, 40, 50) is arranged in a single common housing.

## Revendications

1. Dispositif à sondes de Hall (10) formé sur un corps semi-conducteur, avec
- une première sonde de Hall (10) et une deuxième sonde de Hall (20), dans lequel chaque sonde de Hall (10, 20) présente au moins quatre éléments à effet Hall individuels (220, 240, 260, 280, 320, 340, 360, 380) et les quatre éléments à effet Hall (220, 240, 260, 280, 320, 340, 360, 380) sont connectés en un circuit en série, et dans lequel chaque élément à effet Hall (220, 240, 260, 280, 320, 340, 360, 380) présente trois contacts de raccordement disposés en une ligne (222, 224, 226, 242, 244, 246, 262, 264, 266, 282, 284, 286, 322, 324, 326, 342, 344, 346, 362, 364, 366, 382, 384, 386), dans lequel le contact de raccordement central (224, 244, 264, 284, 324, 344, 364, 384) est disposé directement à proximité entre les deux contacts de raccordement extérieurs (222, 226, 242, 246, 262, 266, 282, 286, 322, 326, 342, 346, 362, 366, 382, 386), et le circuit en série est réalisé au moyen d'une connexion des contacts de raccordement extérieurs (222, 226, 242, 246, 262, 266, 282, 286, 322, 326, 342, 346, 362, 366, 382, 386) respectifs et dans lequel le début et la fin du circuit en série sont en court-circuit l'un avec l'autre et dans lequel les éléments à effet Hall (220, 240, 260, 280, 320, 340, 360, 380) respectifs sont formés dans une région de cuvette de semi-conducteur d'un premier type de conductivité, dans lequel les régions de cuvette de semi-conducteur des éléments à effet Hall individuels (220, 240, 260, 280, 320, 340, 360, 380) sont séparées les unes des autres, **caractérisé en ce que** la première sonde de Hall (20) et la deuxième sonde de Hall (30) sont connectées en parallèle, par le fait qu'un contact de raccordement central (224, 244, 264, 284) d'un élément à effet Hall (220, 240, 260, 280) de la première sonde de Hall (20) est connecté à un contact de raccordement central (324, 344, 364, 384) d'un élément à effet Hall (320, 340, 360, 380) de la deuxième sonde de Hall (30) et un contact de Hall (C1, C2, C3, C4) est associé à chacun des contacts de raccordement centraux connectés (224, 244, 264, 284, 324, 344, 364, 384) et une tension d'alimentation pouvant être appliquée ou une tension de Hall pouvant être prélevée aux contacts de Hall (C1, C2, C3, C4).

2. Dispositif à sondes de Hall (10) selon la revendication 1, **caractérisé en ce que** deux des contacts de raccordement centraux (224, 244, 264, 284, 324, 344, 364, 384) des éléments à effet Hall (220, 240, 260, 280, 320, 340, 360, 380) sont réalisés sous forme de prises de tension de Hall et deux des contacts de raccordement centraux (224, 244, 264, 284, 324, 344, 364, 384) des éléments à effet Hall (220, 240, 260, 280, 320, 340, 360, 380) sont réalisés sous forme de raccords de tension d'alimentation.

3. Dispositif à sondes de Hall (10) selon la revendication 1 ou la revendication 2, **caractérisé en ce que** les éléments à effet Hall (220, 240, 260, 280, 320, 340, 360, 380) présentent une structure de section transversale identique le long de l'extension longitudinale des éléments à effet Hall (220, 240, 260, 280, 320, 340, 360, 380), dans lequel l'extension longitudinale est formée parallèlement aux trois contacts de raccordements disposés en une ligne (222, 224, 226, 242, 244, 246, 262, 264, 266, 282, 284, 286, 322, 324, 326, 342, 344, 346, 362, 364, 366, 382, 384, 386).

4. Dispositif à sondes de Hall (10) selon l'une quelconque des revendications précédentes, **caractérisé en ce que** les éléments à effet Hall (220, 240, 260, 280) de la première sonde de Hall (20) et les éléments à effet Hall (320, 340, 360, 380) de la deuxième sonde de Hall (30) présentent un axe de symétrie (SV) situé entre les deux sondes de Hall (20, 30) et deux des éléments à effet Hall (220, 240, 260, 280, 320, 340, 360, 380) de chaque sonde de Hall (20, 30) présentent la même distance par rapport à l'axe de symétrie (SV).

5. Dispositif à sondes de Hall (10) selon l'une quelconque des revendications précédentes, **caractérisé en ce que** la première sonde de Hall (20) présente exactement le même nombre d'éléments à effet Hall (220, 240, 260, 280, 320, 340, 360, 380) que la deuxième sonde de Hall (30).

6. Dispositif à sondes de Hall (10) selon l'une quelconque des revendications précédentes, **caractérisé en ce que** seuls les contacts de raccordement centraux (224, 244, 264, 284, 324, 344, 364, 384) sont respectivement connectés l'un à l'autre entre la première sonde de Hall (20) et la deuxième sonde de hall (30).

7. Dispositif à sondes de Hall (10) selon l'une quelconque des revendications précédentes, **caractérisé en ce que** les éléments à effet Hall (220, 240, 260, 280, 320, 340, 360, 380) sont réalisés respectivement sous forme d'éléments à effet Hall verticaux (220, 240, 260, 280, 320, 340, 360, 380).

8. Dispositif à sondes de Hall (10) selon l'une quelconque des revendications précédentes, **caractérisé en ce qu'**un circuit intégré est formé sur le corps semi-conducteur, le circuit intégré étant en liaison électrique fonctionnelle avec la première sonde de Hall (20) et la deuxième sonde de Hall (30).

9. Dispositif à sondes de Hall (10) selon l'une quelconque des revendications précédentes, **caractérisé en ce que** chaque sonde de Hall (20, 30) présente plus de quatre éléments à effet Hall (220, 240, 260, 280, 320, 340, 360, 380).

10. Dispositif à sondes de Hall (10) selon l'une quelconque des revendications précédentes, **caractérisé en ce que** tous les éléments à effet Hall (220, 240, 260, 280, 320, 340, 360, 380) d'au moins une des sondes de Hall (20, 30) présentent la même distance par rapport à l'axe de symétrie (SV).

11. Dispositif à sondes de Hall (10) selon l'une quelconque des revendications précédentes, **caractérisé en ce qu'**une troisième sonde de Hall (40) et une quatrième sonde de Hall (50) sont formées sur le corps semi-conducteur et les quatre sondes de Hall (20, 30, 40, 50) sont en liaison électrique fonctionnelle l'une avec l'autre.

12. Dispositif à sondes de Hall (10) selon l'une quelconque des revendications précédentes, **caractérisé en ce que** le corps semi-conducteur est disposé dans un boîtier commun unique avec les sondes de Hall (20, 30, 40, 50).
